# EUROPEAN PATENT APPLICATION

(11) **EP 3 695 719 A1**
(43) Date of publication of application: **19.08.2020**
(21) Application number: 20157520.6
(22) Date of filing: 14.02.2020
(51) Int. Cl.: A01K 97/12, G01D 5/12

(54) **FISHING BITE INDICATOR**

(30) Priority: 16.02.2019 US 201962806761 P
(71) Applicant: Ispot IP Limited, Burnham-on-Crouch CM0 8TE (GB)
(72) Inventor: Jones, David, Milton Keynes, MK19 7AX (GB)
(74) Representative: Dummett Copp LLP

(57) **Abstract**

The present invention provides a bite indicator (10) having a housing (20) , a wheel (12) mounted on the housing (20) to rotate freely about an axle (14) , a surface (22) on the housing (20) for supporting a fishing rod in a position in which a line of the fishing rod makes contact with the wheel (12) to cause the wheel (12) to rotate in response to movement of the line and a sensor (18) for producing an electrical signal with rotation of the wheel (12) . The wheel (12) is mounted in the housing (20) for rotation about an axis that extends horizontally and transverse to the line of the fishing rod when the bite indicator (10) 10 is in use. A magnet (16) 16 is mounted to rotate with the wheel (12) 12 and a tunnel magnetoresistance sensor (18) 18 is provided in the housing (20) to continually monitor and detect the movement of the wheel (12) (and hence the line) very accurately and with a high resolution.

## Description

### FIELD OF THE INVENTION

The present invention relates to a bite indicator, an assembly comprising angling apparatus and a bite indicator and a method of indicating a bite relating to angling apparatus. In particular, the present invention relates to a fishing bite indicator and a bite indicator for use by anglers, the bite indicator having a housing, a wheel mounted on the housing to rotate freely about an axle, a surface on the housing for supporting a fishing rod in a position in which a line of the fishing rod makes contact with the wheel to cause the wheel to rotate in response to movement of the line and a sensor for producing an electrical signal with rotation of the wheel.

### BACKGROUND TO THE INVENTION

Bite indicators usually include either a wheel/drum or a stylus to detect the movement of a fishing line. Both systems can be used in detecting line movements (or deviations) and/or line speed. These bite indicators generally include control means which set a threshold such that if the line deviates by a specific distance or if the line speed increases above a pre-determined threshold then an alarm signal will be generated. However, there is a significant problem of such bite indicators triggering false alarms in the absence of a genuine bite. Such false alarms can cause the anglers to ignore the alarm system and thereby miss any genuine bite.

Bite indicators generally rely on a movement detector which detects movement of the fishing line to which a hook and bait is attached. During a bite, a fish attempts to take the bait and subsequently the fishing line moves. However, such line movement will also occur due to the water movement and weather and other factors. Accordingly, bite indicators commonly emit false alarms which may indicate the occurrence of a bite when no such bite has occurred.

As mentioned above, there are two basic types of fishing bite indicators one is a moving wheel the other a vibration sensor. The moving wheel usually has a magnet or multiple magnets embedded in the wheel or shaft. When the wheel is rotated, the magnetic field influences a reed switch or Hall effect sensor. The vibration sensor usually involves a Piezo electric device but there are other methods detects the movement as the line runs across the sensor.

The current bite indicators can only tell the user that the line is running. They cannot generally tell direction, distance, and speed of line movement or cater for environmental condition changes such as wind or currents. In addition, the user interface is limited with a sounder and/or a flashing LED being the only indicator(s) of line movement. Sensitivity is limited by the number of magnets affixed to the wheel. The fixed nature of the magnets means that the user cannot change the sensitivity to meet differing conditions. In addition, the high current usage of the Hall effect sensors leads to short battery life and is affected by temperature changes.

Bite indicators may be provided with sensitivity controls such that an alarm is only produced if the line moves beyond a certain distance or deviates by a specific amount or if the speed of the line movement is above a pre-determined threshold. However, environmental conditions (water currents and/or weather/wind) can still cause such alarms to trigger. If the angler sets the sensitivity too low, then the angler may not receive such false alarms. However, the angler may also miss real and genuine bites. Accordingly, it is difficult and skilful for an angler to set the sensitivity according to the actual conditions since the indicating parameter (line deviation or line speed) may still be triggered by fluctuating environmental conditions rather than purely by a genuine bite.

The vibration sensors using piezoelectric devices can be too sensitive due to the sensor picking up vibrations from non-line movements such as wind and from any other vibration affecting the rod such as knocking the rod or walking close by. The detection of line movement depends on the friction between the line and the sensor, this produces wear on both the line and the sensor.

Both of these methods can only detect that the line has moved. This means that they can only be used in fishing conditions were the line is not constantly moving. The technologies of these detectors means there is limited scope for the information the user receives and have limited user programmability to cater for the many differing conditions encountered whilst fishing.

As mentioned above, bite indicators are commonly used by anglers in order to help signal the occurrence of a bite on angling apparatus. In particular, carp anglers frequently use such bite indicators which provide an audible and/or visual signal indicating the occurrence of a bite.

Bite indicators of the type using a wheel engaged and rotated by a fishing line are well known and described for example in GB 1 503 596. The wheel is mounted on an axle that carries a member which forms part of a photoelectric, magnetic or electromagnetic sensor which provides an electrical signal indicative of any such movement and its rate. In particular, the sensor produces electrical pulses as the wheel rotates and the repetition frequency of these pulses increases with the speed of rotation of the wheel. The electrical pulses are used to produce audible and/or visible alarm signals to warn the angler of a bite.

In this type of bite indicator, it has also been proposed to provide a control to vary the sensitivity. EP 0 570 117 varies the sensitivity using a counter. The pulses generated by the sensor are applied to a counter which in turn activates the associated alarm circuit. As a result, an audible or visible alarm signal is only produced after a selected number of electrical pulses have been produced by the sensor.

The sensitivity adjustment proposed in EP 0 570 117 only sets the length of line movement that can take place before a sound is emitted. If the line is constantly moving, for example on account of a water current or wind conditions, a sound is generated with every given length of line movement regardless of how slowly or rapidly that movement takes place. The only effect of altering the counter to vary the sensitivity is to vary the number of audible or visible pulses that a given length of line movement will produce.

It is an aim of the present invention to overcome at least one problem associated with the prior art whether referred to herein or otherwise.

### SUMMARY OF THE INVENTION

According to a first aspect of the present invention, there is provided a bite indicator comprising a housing, a wheel supported by the housing and mounted on an axle for rotation, a surface on the housing for supporting a fishing rod in a position in which a line of the fishing rod makes contact with the wheel to cause the wheel to rotate in response to movement of the line and a sensor for producing an electrical signal with rotation of the wheel, wherein the bite indicator comprises a magnet mounted to rotate with the wheel and the sensor comprises a tunnel magnetoresistance sensor.

The wheel may be mounted on the axle to rotate freely about a central axis of the axle. Preferably the axle is a fixed axle and the wheel rotates with the axle.

Preferably the wheel is mounted on the housing. The housing may comprise an opening (groove) within which at least a part of the wheel is exposed.

Preferably the sensor produces an electrical signal which varies throughout 360 degrees of movement of the magnet.

Preferably the sensor produces an electrical signal which varies sinusoidally with the angular position of the magnet.

The electrical signal may comprise an analogue signal which represents the angular position of the magnet.

Preferably the electrical signal is unique to the angular position of the magnet throughout 360 degrees and the angular position within the maximum 360 rotation of the magnet may be indicated solely by the electrical signal.

Preferably the sensor comprises a tunnel magnetoresistance (TMR) angle sensor to (continually) monitor and /or detect the angular position of the wheel.

Preferably the magnet is concentrically mounted relative to the wheel.

The magnet may be mounted on an end of the axle. The axle may comprise a shaft and the magnet may be secured to an end of the shaft. The wheel may be located along the shaft and preferably located centrally or mid-way between a first longitudinal end and a second longitudinal end of the shaft.

Preferably a single or sole magnet is concentrically mounted relative to the wheel. The axle may comprise a counterbalance (or counterweight) mounted in opposition to the (sole/single) magnet. The magnet may be located at or on a first longitudinal end of the shaft and the counterbalance may be located at or on a second longitudinal end of the shaft. The wheel may be located midway between the magnet and the counterbalance. The counterbalance may have a weight and/or size which is the same as (matched to) a weight and/or size of the magnet. The counterbalance may comprise a (circular) metal (disc) member.

The magnet may comprise an outer circular periphery/circumference.

The magnet may comprise a diametrically magnetised magnet and may have a north pole and a south pole on opposite curved sides.

The polarity of the magnet may be split (or divided) along a diameter of the magnet. Accordingly, a first semi-circular portion or semi-cylindrical portion (or hemi-cylindrical portion) may provide a south pole and a second semi-circular portion or semi-cylindrical portion (or hemi-cylindrical portion) may provide a north pole.

The magnet may comprise a disc magnet or cylindrical magnet. The magnet may comprise an annular magnet or ring magnet.

The magnet may comprise a neodymium magnet. The magnet may comprise a ferrous magnet or may comprise a samarium cobalt magnet.

The magnet may comprise a face which faces (towards) and is located spaced apart from the TMR sensor. The face may be divided to provide a north pole and a south pole. The north pole portion may extend around substantially 180 degrees of the face and the south pole may extend around substantially 180 degrees of the face.

Preferably the bite indicator comprises an alarm circuit for producing an (audible or visible) alarm signal which may be triggered by predetermined parameters.

Preferably the bite indicator comprising a signal processor to monitor the output from the TMR sensor. The signal processor may be arranged to periodically measure the output from the TMR sensor. The period between measurements may be adjusted/altered/changed. The signal processor may comprise a first period and a second period between consecutive measurements depending upon a detected state of the bite indicator. The period may be changed from the first period to the second period by a change of state from a stable state to a potential alarm state. In the stable state the period may be substantially 100 milliseconds (the period between consecutive measurements of the TMR signal) and, in the alarm state, the period may be 10 milliseconds (the period between consecutive measurements of the TMR signal in the alarm state).

The change of state may be caused by a change of a detected parameter. The change of state may be caused by the bite indicator sensing a change of a monitored signal relative to a threshold. The change of state may be caused by the bite indicator sensing a change of movement in the line beyond a predetermined threshold position and/or a change in the (magnitude of the) velocity of the line above a predetermined threshold velocity and/or a change in the (magnitude of the) acceleration above a predetermined threshold acceleration.

The bite indicator may comprise a monitoring system to switch the state from a stable state to an alarm state. The monitoring system may monitor the line between the periodic monitoring of the TMR signal. For example, this monitoring system may switch the status from a stable state to an alarm state within the set (100 ms) period of measurement (i.ee. in between consecutive measurements) of the TMR signal in the stable state.

The bite indicator may comprise filtering means to filter potential false alarms. The filter means may allow for a change in the displacement of a parameter within a pre-set range without triggering an alarm signal. For example, the filtering means may allow for a forward movement up to a forward threshold and may allow for a backward movement up to a backward threshold. Accordingly, any movement of the line within this range will not trigger an alarm signal. Alternatively, or additionally, the filtering means may allow for a forward velocity (and/or acceleration) up to a forward threshold and may allow for a backward velocity (and/or acceleration) up to a backward threshold.

The filtering means may allow a steady (non-sudden/rapid) change in a parameter without triggering an alarm signal.

The bite indicator may comprise conversion means to convert angular movement detected by the TMR sensor to a linear movement of the line. The conversion may provide an output of linear displacement and/or linear velocity (speed) and/or linear movement direction and/or linear acceleration of the line. The linear values may be output to a remote device (for example, mobile phone) and/or may be displayed directly of the bite indicator.

The bite indicator may comprise a screen. The screen may be provided on a front surface of the housing of the bite indicator. The screen may display movement parameters of the line and may display the linear displacement and/or linear movement direction and/or linear velocity and/or linear acceleration of the line.

The bite indicator may comprise an activation device. The activation device may change the bite indicator from a non-operational state to an operational state. Preferably the activation device comprises a rod sensing device which senses the position of a rod in an operational position relative to the bite indicator. Preferably the activation device comprises a rod proximity sensor which detects the proximity of a rod within a retained position on the bite indicator.

An alarm signal may not be triggered by the length of line moving over the wheel but by its speed of movement and/or a change of movement and/or a change of direction of movement. For example, a short and/or fast movement of the line may suffice to generate an alarm signal whereas several metres of line can be drawn from the reel without an alarm being generated provided the speed of the line movement remains substantially constant/uniform.

The alarm signals generated by a bite indicator of the present invention may provide the angler with more meaningful information since the resolution of the wheel angle is constantly monitored.

Preferably the TMR sensor indicates the angular position of the wheel with a resolution of greater than 180 degrees and preferably greater than 90 degrees and more preferably greater than 45 degrees.

The TMR sensor may provide a resolution for the angular position of the wheel of between 0 and 5 degrees and preferably substantially between 0 and 2.5 degrees. The angular resolution may be less than 2 degrees (i.e. between 0 and 2 degrees) and preferably is less than 1.5 degrees (i.e. between 0 and 1.5 degrees). More preferably the angular resolution may be substantially 1 degree.

The fishing bite indicator may utilise newer technology known as tunnelling magnetoresistance. This allows the indicator to measure to a level of accuracy previously unobtainable from Piezo and Hall effect technologies. The software behind the technology is unique in preferably converting angular movement into linear information of speed, direction and distance. The information may be graphically displayed on a screen incorporated within the unit. All information may be sent to any Bluetooth capable device over long range. The warning LED (light emitting diode) may use RGB (red, green and blue) prism technology with 16 million colours and the colours may be user programmable.

The technology and software may allow measurement of line movement from zero to any distance e.g. 1 mm to 99 m (or other non-metric units of measurement), the sensitivity may be set by the user. The technology may allow detection of forward and backward motion of the line each with its own user programmable trigger point. The app may allow for the use of multiple bite indicators by using user defined unique identifiers preventing interference between systems. A unique filter mechanism (called Rocking Chair filter) may allow the user to define parameters to allow for the natural flow of water and so doesn't send unnecessary warnings. A unique filter mechanism (called Drift filter) may allow the user to define a level of drift that is acceptable and so doesn't send unnecessary warnings. The combination of technology and software may allow for the speed of line movement to be calculated and displayed, preferably as RPM (revolutions per minute), but can be other units of speed.

A rod detection system may be used as an on/off switch, an auto mute system, a security system and a safety system to warn of possible danger to the rod. Application software which is available on all platforms and Bluetooth enabled may allow the user to update all programmable parameters, has a log of all events and receives notifications such as warnings, weather and bait timers.

According to a second aspect of the present invention, there is provided an angling assembly comprising a rod, a reel, a fishing line and a bite indicator, the bite indicator comprising a housing, a wheel supported by the housing and mounted on an axle for rotation, a surface on the housing for supporting the fishing rod in a position in which the line of the fishing rod makes contact with the wheel to cause the wheel to rotate in response to movement of the line and a sensor for producing an electrical signal with rotation of the wheel, wherein the bite indicator comprises a magnet mounted to rotate with the wheel and the sensor comprises a tunnel magnetoresistance sensor.

According to a third aspect of the present invention, there is provided a method of indicating a fishing bite, the method comprising
providing a bite indicator comprising a housing, a wheel supported by the housing and mounted on an axle for rotation, the bite indicator further comprising a sensor for producing an electrical signal with rotation of the wheel, wherein the bite indicator comprises a magnet mounted to rotate with the wheel and the sensor comprises a tunnel magnetoresistance sensor; and
supporting a fishing rod on a surface of the housing in a position in which a line of the fishing rod makes contact with the wheel to cause the wheel to rotate in response to movement of the line.

### BRIEF DESCRIPTION OF THE DRAWINGS

The present invention will now be described, by way of example only, with reference to the drawings that follow, in which:
Figure 1 is a front view of a preferred embodiment of a fishing bite indicator in accordance with the present invention;
Figure 2 is a front schematic view of a preferred embodiment of a fishing bite indicator in accordance with the present invention; and
Figure 3 is a front view of a preferred embodiment of a sensor assembly located within a housing of fishing bite indicator in accordance with the present invention.

### DESCRIPTION OF THE PREFERRED EMBODIMENTS

The present invention provides an improved fishing bite indicator 10 (alarm) which includes a single sensor which monitors small movements of a fishing line and simultaneously detects the direction of movement of a fishing line. Prior art bite indicators may include a first sensor for monitoring the movement of a fishing line but would (if required) need a second sensor to accurately detect the direction of movement of the fishing line. In addition, prior art movement sensors do not monitor the movement of the fishing line with a high resolution. The present invention utilises a wheel which is rotated by movement of a fishing line passing over an upper circumferential arc. This is a reliable system.

These wheel systems rely on an individual magnet or several magnets which cooperate with a reed switch or reed switches to detect the rotation of the wheel. Accordingly, the resolution of these systems is low. A number of small magnets can be secured to the wheel but this is limited and the size and accurate/reliable securement of a number of magnets would be problematic. The size of the wheel may be also increased to enable a greater number of magnets to be secured reliably to the wheel. However, the size of the wheel is limited due to practical considerations and an overly large wheel also causes problems with the overall sensitivity. For these products and for the present invention, the term wheel is used to define any suitable rotatable member and does not refer to the transportation over a surface.

As mentioned above, bite indicators proposed in prior art systems only detect line movement with a low resolution such that the monitoring of the line is not accurate and small movements may not be detected and/or such a sensor cannot distinguish between the direction of movement of the line. Prior art systems may produce a continuous stream of alarm signals even though no bite has occurred. Reducing the sensitivity would reduce the rate at which the such false alarm signals are produced but at the same time it would render the bite indicator insensitive to a bite that only causes a short line movement.

As is well recognised, regardless of the sensitivity of an alarm system, it is only as good as its false alarm rate. Thus, in the prior art, at least under some conditions, genuine bite alarm detection signals would go unnoticed in the constant stream of false alarms.

In the preferred embodiment of the invention, the resolution of the sensor is such that very small movements of the line can be detected and also the direction of the line movement can also be identified.

Conventionally, the wheel used in bite indicators is disc like, that is to say its diameter greatly exceeds its axial thickness. The axle on which the wheel is mounted carries the member that interacts with a sensor to enable rotation of the wheel to be detected. The member may for example be a paddle that interrupts the light path between a light emitting diode (LED) and a phototransistor but electro-optical sensing severely affects battery life because the LED has to operate constantly. It is generally preferred instead to use magnets that are detected by a reed switch or a Hall effect device. When magnets are used, the prior art configuration limits the number of electrical pulses that can be produced by the detector during each rotation of the wheel.

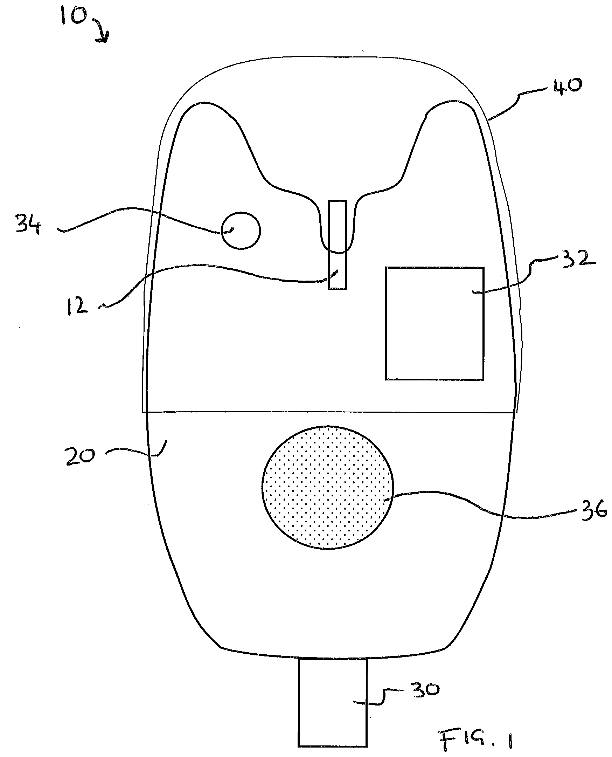

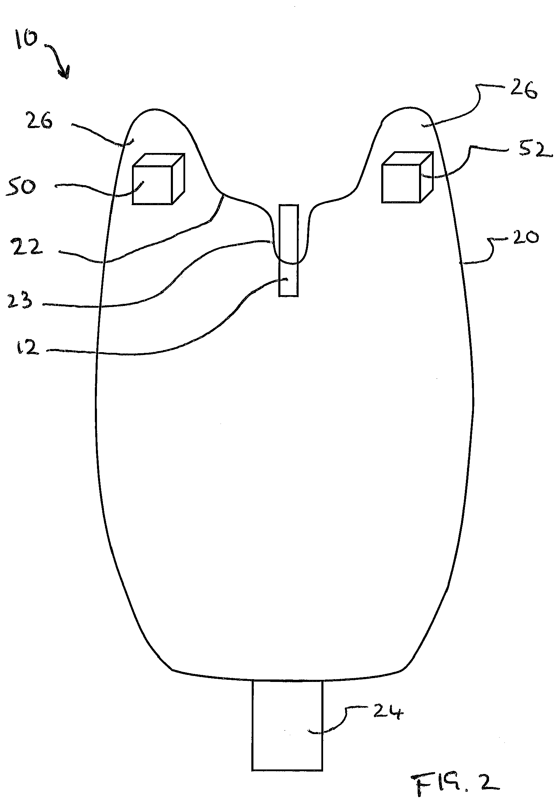

As shown in Figure 1, Figure 2 and Figure 3, the present invention provides a bite indicator 10 having a housing 20, a wheel 12 mounted on the housing 20 to rotate freely about an axle 14, a surface 22 on the housing 20 for supporting a fishing rod in a position in which a line of the fishing rod makes contact with the wheel 12 to cause the wheel 12 to rotate in response to movement of the line and a sensor 18 for producing an electrical signal with rotation of the wheel. The wheel 12 is in the form of a drum mounted in the housing for rotation about an axis that extends horizontally and transverse to the line of the fishing rod when the bite indicator 10 is in use.

A magnet 16 is mounted to rotate with the wheel 12 and a TMR sensor 18 is provided in the housing 20 to continually monitor and detect the movement of the wheel 12 (and hence the line) very accurately and with a high resolution.

Electronic bite indicators are commonly used with a line tensioner which may take the form of a free weight that will move up and down as the line tension increases and decreases. More commonly, the line tensioner includes a pivoted weighted arm or a resiliently bendable arm that acts to tension the arm. The arm is connected to the line by a line clip that is designed to release the line automatically when the angler strikes and lifts the rod off its rest.

The bite indicator 10 shown in Figure 1, Figure 2 and Figure 3 comprises a housing 20 containing an electrical circuit and a battery powering the electrical circuit. The electrical circuit is controlled remotely and an activation device or button is provided on the housing 20 to switch the power to the electrical circuit from the internal battery on and off. The activation device comprises an automated system whereby a proximity sensor 50, 52 detects the position of the rod in the resting position on the bite indicator 10 and thereby automatically activates the electronic bite indicator 10. The proximity sensor comprises a photoelectric sensor and may have a transmitter 50 and a corresponding receiver 52 to detect the presence of a rod between the projections 26 and in an operative position. In further embodiments, other suitable proximity sensors may be used. For example, an inductive or magnetic proximity sensor could be arranged to detect the presence or absence of a rod.

The proximity sensor also provides an alert to signal the unexpected removal of the rod. For example, in a carp bite, the rod may be pulled away and towards (or into) the water and the proximity alert would signal the user of this situation.

A screw thread 30 is provided at the lower end of the housing 20 to allow the housing 20 to be secured to a rod rest. At its upper end, two projections 26 are provided. The projections 26 prevent a rod resting in a recess which forms a supporting surface 22 from moving from side to side and coming away from the bite indicator 10, even when the fishing line is dragged sideways. The projections 26 also resist accidental displacement of the rod still further, so that the rod is captured and cannot escape when a lateral force is applied to it but can be pulled out readily if raised vertically by the angler.

A groove 23 positioned centrally beneath the recess 22 allows the line of the fishing rod to make contact with the (freely) rotatable wheel 12.

The wheel 12 is disposed outside the housing 20 of the bite indicator 10 and is made of a polished, faceted, transparent plastics material.

The bite indicator 10 includes a TMR sensor 18 mounted in the housing 20 of the bite indicator 10. In addition, the wheel 12 is mounted on an axle 14 or shaft which rotates with the wheel 12. A magnet 16 is mounted at or on one (longitudinal) end of the shaft 14. In particular, the magnet 16 is mounted adjacent to but spaced apart from the TMR sensor 18.

The magnet 16 comprise a diametrically magnetised magnet and has a north pole and a south pole on opposite curved sides. The magnet 16 comprise an outer circular periphery/circumference.

The polarity of the magnet 16 is split (or divided) along a diameter of the magnet 16. Accordingly, a first semi-circular portion or semi-cylindrical portion (or hemi-cylindrical portion) provides a south pole and a second semi-circular portion or semi-cylindrical portion (or hemi-cylindrical portion) provides a north pole.

In the preferred embodiment, the magnet 16 comprises a disc magnet or cylindrical magnet. In some embodiments, the magnet 16 comprises an annular magnet or ring magnet.

The present invention utilises a single or sole magnet 16 which is concentrically mounted relative to the wheel 12 to provide a high angular position resolution. As mentioned above, a prior art system may attempt to use a number of individual magnets located in an annular configuration to be detected by a reed switch (or reed switches). Such an arrangement may increase the angular position resolution up to 90 degrees for example. However, such an arrangement results in the shaft 14 not being balanced due to the uneven distribution of the weight around the shaft 14. This may cause relatively small resistive force to be generated in certain positions. This can cause inaccuracies and also may lead to the fishing line sliding over the top surface of the wheel 12 rather than causing the wheel 12 to rotate. The line and/or wheel 12 may be wet which increases the likelihood of such a problem. To overcome this, a counterbalance 70 may be located on the axle 14.

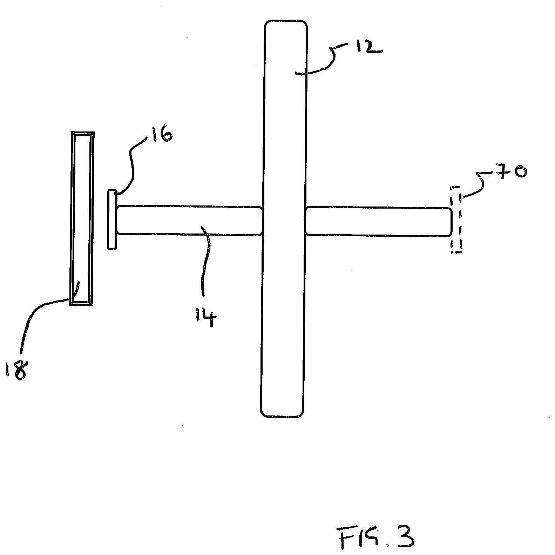

As shown in Figure 3, the axle 14 may comprise a counterbalance 70 mounted in opposition to the (sole/single) magnet 16. The magnet 16 is located at or on a first longitudinal end of the shaft 14 and the counterbalance 70 is located at or on a second longitudinal end of the shaft 14. The wheel 12 is located midway between the magnet 16 and the counterbalance 70. The counterweight 70 has a weight and/or size which is the same as (for example, matched to) the weight and/or size of the magnet 16. The counterbalance 70 comprise a circular metal disc member.

The magnet 16 comprises a neodymium magnet. In other embodiments, the magnet 16 could be a ferrous magnet or a samarium cobalt magnet. The magnet 16 comprises a face which faces (towards) and is located spaced apart from the TMR sensor 18. The face is divided to provide a north pole and a south pole. The north pole portion extends around substantially 180 degrees of the face and the south pole extends around substantially 180 degrees of the face.

The TMR sensor 18 is positioned within the housing 20 to detect the position of the magnet 16 mounted to the shaft 14 and/or wheel 12. The TMR sensor 18 produces an electrical signal which varies with the relative rotational position of the magnet 16. This signal varies as the rotational position of the magnet 16 moves through 360 degrees.

The bite indicator 10 includes a signal processor which receives the electrical output from the TMR sensor 18. The signal processor and the control system for the bite indicator 10 monitor the signal from the TMR sensor 18 and the signal (or movement parameters extracted therefrom) can be monitored against predetermined thresholds and rules to decide if an alarm signal should be emitted.

The control system comprises a sampling circuit in order to monitor the signal from the TMR sensor 18 periodically. This significantly increase the life of the battery and enables the bite indicator 10 to be used for longer.

For example, the signal from the TMR sensor 18 may be measured every 100 ms. However, the control circuit is arranged to reduce this time period in the event of a change of state of the bite indicator, for example a transition from a stable state to a (potential) bite state. This may result in a reduction of the time period from 100 ms to 10 ms to provide more detailed analysis of the movement of the line. Furthermore, the bite indicator 10 may also have a control system whereby, on detection of a significant movement, the measurement frequency is automatically increased even before this is detected by the normal measurement of the TMR signal, i.e. a significant movement detected in between the analysis of two consecutive periodic TMR signals (within the 100 ms time frame).

The bite indicator 10 may include a remote control unit and/or may communicate with a mobile telephone using Bluetooth.

The mobile phone has its own transmit/receive circuit which communicates with the circuit in the housing 20 of the bite indicator 10. The mobile phone serves both to control the bite indicator 10 and to display and record various settings. The mobile phone produces sounds and visual notifications, flashing lights etc. as well as alarm signals being produced by the bite indicator 10 to warn the angler of a bite when out of sight of the rod and the bite indicator 10.

The remote control unit or the mobile phone comprises a control to enable the angler to set the parameters (e.g. threshold displacement, threshold velocity, threshold acceleration) that produces an alarm, as well controls and to the tone and volume, respectively, of the emitted sound. On the remote control unit these parameters may be set using up/down buttons.

This fishing bite indicator 10 is the first user programmable indicator that can be used in all fishing conditions and uses new technology to give a greater degree of accuracy and detailed information to the user.

The present invention utilises a moving wheel sensor. The present invention seeks to provide a solution to an aforementioned problem by providing a fishing bite indicator 10 with a sensor comprising a tunnelling magnetoresistance (TMR) sensor 18.

TMR represents a huge leap in technology compared to all fishing bite indicators now available. It has a much smaller package size, excellent thermal stability and better sensitivity. This leads to a sensitivity 1000 times more sensitive than the Hall effect whilst consuming only a few micro amps of current. Using this technology allows the system to know the angular position of the wheel 12 at all times leading to incredible accuracy.

This technology allows a number of user programmable filters to be incorporated so that the use of the fishing bite detector 10 can be used in all forms of fishing.

The information provided to the user can be in terms of speed, distance and direction in the form chosen by the user.

Preferably, this information is displayed on an OLED display 32 on the fishing bite indicator 10 (or any other form of display) whilst also being transmitted by Bluetooth to any Bluetooth compatible device, e.g. mobile phone. The display screen 32 may display the displacement of the line in 1 mm increments either +ve or -ve from a starting position. The control system may then emit an audible alarm from a speaker 36 mounted in the hosing at the pre-set threshold (e.g. +10 mm or -5 mm). Accordingly, backward bites or drop back bites can be detected at a different (lower) level of line displacement. The audible alarm may also signify the speed of movement of the line with a series of beeps being emitted to reflect the speed, i.e. rapid beeps for a high velocity and slow spaced apart beeps for a low velocity.

A new rod detection system has been incorporated. This allows the user to know about the security of the rod, e.g. "has it been moved? Is the bite large enough to pull the rod into the water?". In addition, the rod detection system is used as a battery saving mechanism by switching to low power mode if the rod is not on the fishing bite indicator 10. The rod detection system also allows the user to mute the sound of the fishing bite indicator 10 whilst winding in the line after casting.

The warning light is a multi-coloured RGB LED 34 incorporating prism technology programmable by the user.

The fishing bite indicator 10 can be used as a stand-alone machine or linked to a Bluetooth enabled device to receive information, or connected to a Bluetooth enabled device to update user-programmable parameters.

Preferably the core technology to this improved fishing bite indicator 10 is the use of tunnelling magnetoresistance (TMR). The fishing line passes over the wheel 12. The wheel 12 has a circular (disc) magnet 16 attached to the shaft 14 which allows the movement of the wheel 12 to be detected by as little as 0.1 degree in either forward or backward direction. The degree of movement of the wheel 12 and the rate of movement of the wheel 12 are used to convert the angular movement into the linear information of direction, speed and distance that the line has moved.

This core technology allows a much greater degree of information to be made available to the user in new ways using displays on the fishing bite indicator 10 and Bluetooth technologies and apps on any Bluetooth compatible device. This detailed information allows the fishing bite indicator 10 to inform the user in a number of ways.

Forward Bite: this is the most usual way of using the device. Depending on the conditions, the user will set the distance of travel the line can go before an alert is triggered. This can be any distance from 1 mm to 99 metres (or the non-metric equivalent). When the alert is triggered the warning light will activate, the sounder will emit a sound which reflects the speed of the bite and the information is displayed on the inbuilt display. If the Bluetooth app is being used, then this information is also sent to the Bluetooth device.

Back Bite: Depending on the conditions, the user will set the distance of travel the line can go before an alert is triggered (independently of the Forward Bite setting). This can be any distance from 1 mm to 99 cm (or the non-metric equivalent). When the alert is triggered, the warning light will activate, the sounder will emit a sound which reflects the speed of the bite and the information is displayed on the inbuilt display. If the Bluetooth app is being used, then this information is also sent to the Bluetooth device.

Rocking Chair Filter: This filter recognises when the natural flow of the water moves the line forwards and backwards e.g. water currents, wind, beach waves (in and out), boat rocking due to swell. It works by the user setting a forward and backward trigger limit. For example, the forward bite trigger is set to 10 cm and the backward bite trigger set to -5 cm, this allows line to move continuously from 9 cm to -4 cm without triggering an alert.

Drift Filter: This allows the user to set parameters to ignore very slow movements in the line due to currents etc. and not to generate an alert. This is programmable for off, low, medium and high levels of drift. In addition, the user can set an overall distance the line can travel, due to drift, before an alert is made. This alert has a different warning sound from a bite alert and different graphics on the display and can also be sent via Bluetooth to a compatible device. The dedicated app also displays the amount of drift to enable the user to decide whether to take any action. For example, if there has been a significant drift then it can be difficult to achieve a successful strike due to the amount of slack line. Accordingly, the display of this information by the app may alert the user to this risk.

Detection Methods: The bite indicator 10 has two methods of detecting a bite, the parameters of which are user programmable. The first is using distance, examples of which are above. The second method is measuring the flow rate of the line. This new method no longer takes into account the amount of line that has passed the indicator but the speed at which the line is moving. This allows the user to use the fishing bite indicator 10 for different types of fishing such as beach, boat and indeed all types of fishing. This is a completely new method of detection which has its own set of programmable parameters. The information (preferably RPM but could be any other unit indicating speed) are shown on the display 32 on the fishing bite indicator 10 and have a different warning sound. This information can also be sent via Bluetooth to compatible devices.

The bite indicator 10 may utilise a combination of the RPM together with some information relating to the drift or displacement of the line. For example, a modest increase in the RPM which is not above the threshold level may still be a potential alert if, for example, the displacement goes above a particular level. Accordingly, a combination of the increase in the RPM (below an independent threshold) and an increase in the displacement (below an independent threshold) may signal an alert of a potential bite. The thresholds may be cumulative such that a speed increase to 75% of the threshold may be combined with a 25% or 50% or 75% threshold for the displacement prior to an alert being generated. Again, these setting may be pre-set and adjusted by the user. Accordingly, the bite indicator 10 may not rely on the RPM in isolation and even if the RPM is not high enough to trigger an alert the displacement may indicate something untoward which warrants an alert signal.

Rod Detection system: This is used to detect the presence of a fishing rod and serves several purposes. It can power down the device automatically when no rod is detected on the fishing bite indicator and thus eliminates the need for a power on/off button. After casting and the rod returned to the fishing bite indicator 10 the rod detection system mutes the sounder for a period of time whilst the slack line is taken in. This is a user programmable time period in seconds. When the rod is returned to the fishing bite indicator 10 a Bluetooth connection is made for a period of time (programmable) to enable the user to update the parameters. The rod detection system also enables a degree of security by sending an alarm when the rod is removed, this can be switched on or off in the app.

Battery: The battery in the device is monitored and a warning is triggered both on the fishing bite indicator as well as sending a message via Bluetooth to a compatible device.

Supporting App (all platforms): Whilst the fishing bite indicator 10 can be used in stand-alone mode, it is also possible to control it from a Bluetooth compatible device via the app. The app allows the user to update all the user programmable parameters e.g. volume of sounder, tones, trigger points. It allows the user to set the colours of the LED 34 (useful in a multi-detector environment). It links to local weather report, has a complete log of alarms etc. It can set a bait timer from the moment the rod is placed on the detector and warns how long the bait has been out.

The app may include a number of pre-set settings which may relate to specific fishing characteristics. For example, the app may enable a user to select "river", "lake" or "beach" and this automatically recalls the parameters set for this type of fishing. This may include the thresholds for the drift, the threshold for the RPM and/or the range for the rocking chair filter. Such setting may be saved but can be changed by the user. In addition, the app may provide a "custom" setting in which a user's preferred settings are saved.

The app may also provide a playback feature whereby the characteristics of a bite can be replayed, for example on the mobile phone. This may enable a reconstruction of the bite to be displayed (e.g. the data, speed, displacement etc.). Accordingly, a user will be able to demonstrate to friends a successful (or unsuccessful) bite and the outcome of the bite. Such a demonstration may include a graphical reconstruction. This may also help in selecting/adjusting the settings and may also be used for entertainment purposes.

Bluetooth (all platforms): The fishing bite indicator 10 utilises Bluetooth to communicate at long range with any Bluetooth compatible device. Use of Bluetooth allows multiple fishing bite indicators 10 to be used by allowing unique user identifiers preventing interference between indicators and users.

Protective sheath: As the fishing bite indicator does not have an on/off button it is important to cover it to stop the accidental switching on and to protect the display screen, see Figure 1.

Clip on Jackets: As it is possible to use multiple fishing bite indicators 10 it is useful to have jackets that are different colours, textures and materials e.g. rubberised, camo, and metallic.

The fishing bite indicator 10 utilises newer technology known as tunnelling magnetoresistance. This allows the indicator 10 to measure to a level of accuracy previously unobtainable from Piezo and Hall effect technologies. The software behind the technology is unique in converting angular movement into linear information of speed, direction and distance. The information is graphically displayed on a screen 32 incorporated within the unit. All information can be sent to any Bluetooth capable device over long range. The warning LED 34 uses RGB prism technology with 16 million colours and the colours are user programmable.

The technology and software allows measurement of line movement from zero to any distance e.g. 1 mm to 99 m (or other non-metric units of measurement), the sensitivity can be set by the user. The technology allows detection of forward and backward motion of the line each with its own user programmable trigger point. The app allows for the use of multiple bite indicators by using user defined unique identifiers preventing interference between systems. A unique filter mechanism (called Rocking Chair filter) that allows the user to define parameters to allow for the natural flow of water and so doesn't send unnecessary warnings. A unique filter mechanism (called Drift filter) that allows user to define a level of drift that is acceptable and so doesn't send unnecessary warnings. The combination of technology and software allows for the speed of line movement to be calculated and displayed, preferably as RPM, but can be other units of speed.

A rod detection system that is used as an on/off switch, an auto mute system, a security system and a safety system to warn of possible danger to the rod. Application software which is available on all platforms and Bluetooth enabled that allows the user to update all programmable parameters, has a log of all events and receives notifications such as warnings, weather and bait timers.

The present invention provides a biaxial magnetic angle sensor (TMR sensor 18) for use on a bite detector 10. In particular, the bite indicator 10 uses a biaxial angle magnetic sensor to detect the movement of a wheel 12 over which fishing line passes. An example of such a sensor 18 is the TMR3002 manufactured by Multidimension Technology Co Ltd.

The present invention also uses time slicing to enhance battery life. If the TMR chip is powered up continually the current drain would reduce battery life. In the present invention, the TMR chip is powered up every 100 milliseconds. When not awake the TMR chip is not active and is drawing no current. If the line moves very slowly when the TMR chip is awake every 100 milliseconds, slow 'creep' of the line can be detected by the TMR sensor registering rotation of the diametrically magnetised magnet to produce an output, but such slow movement is not consistent with the movement of the line if the fish bites the bait, and no action is taken.

The present invention also provides a pre-set threshold to switch the sensor 18 into rapid response mode. The present invention comprises a threshold value for the output from the TMR sensor 18 such that when this threshold is exceeded the TMR chip is powered up every 10 milliseconds to provide a much higher sampling rate. Once this sequence is initiated action can be taken to interpret the output to notify the angler.

If there is a 'take' and the fish runs with the line, then the present invention uses an external electronic high pass filter, added to the TMR sensor 18, that gives a digital output which is used to wake the micro immediately and void the 100 millisecond delay. This ensures that no line movement is 'lost' in the remaining 90 milliseconds that would have elapsed before the next position was read by the sensor.

The high pass filter detects a rate of change in rotary movement that is greater than a pre-set threshold value. As soon as this threshold is detected it switches an interrupt to the micro that initiates the 10 millisecond sampling rate. This ensures that no line movement will be missed. The threshold value can be set in software. The output from the TMR sensor 18 is also used to allow the bite detector 10 to be activated by line movement distance or line movement speed or both.

In summary, unlike any other bite detection technology currently in the market the tunnelling magnetoresistance sensor 18 provides a resolution of 1 degree of rotation. So this allows accurate measurement of both RPM and distance of line movement.

Typically, with existing magnetic sensors, in which 2 or 4 magnets are incorporated into the sensor wheel, the resolution is only 90 or 180 degrees of rotation. So even with a 4 magnet sensor, detection of movement is relatively gross. An advantage of the fine resolution of the tunnelling magnetoresistance sensor 18 is that measurement accuracy is dramatically increased. The diameter of the sensing wheel can be altered to increase or decrease the amount of line movement detected per 1 degree of rotation.

The TMR sensor 18 cooperates with circular magnets 16 referred to as diametrically magnetised devices. Normally circular magnets have one circular face magnetised as a north pole and one circular face as a south pole. Diametrically Magnetised devices are different. The polarity is split vertically down the centre of the cylindrical magnet 16 such that one half is a north pole and the other half is a south pole. Accordingly, the circular magnet can be represented as a clock face and the division between the north and south poles extends from the 12 o clock position to the 6 o clock position. Travelling clockwise the polarity from 12 to 6 is north and the polarity from 6 to 12 is south. As the magnet rotates the terminator between the two poles sweeps around like a clock hand and the sensor detects this movement, as long as the sensor is aligned on the rotational axis of the magnet.

Overall, as soon as a carp starts to tug at the line, the very fine resolution of the tunnelling magnetoresistance sensor 18 allows for the thresholds programmed into the circuitry to activate alarm states much more quickly than any other technology currently in the market. So the technology offers much faster response times.

Arrangements of the invention are further described in the following numbered list of clauses.
Clause 1: The fishing bite indicator utilises newer technology known as Tunnelling magnetoresistance. This allows the indicator to measure to a level of accuracy previously unobtainable from Piezo and Hall Effect technologies
Clause 2: The software behind the technology is unique in converting angular movement into linear information of speed, direction and distance.
Claim 3: The information is graphically displayed on a screen incorporated within the unit.
Clause 4: All information can be sent to any Bluetooth capable device over long range.
Clause 5: The warning LED uses RGB prism technology with 16 million colours and the colours are user programmable.
Clause 6: The technology and software allows measurement of line movement from zero to any distance e.g. 1mm to 99m (or other non-metric units of measurement), the sensitivity can be set by the user.
Clause 7: The technology allows detection of forward AND backward motion of the line each with its own user programmable trigger point.
Clause 8: The app allows for the use of multiple bite indicators by using user defined unique identifiers preventing interference between systems.
Clause 9: A unique filter mechanism (called Rocking Chair filter) that allows the user to define parameters to allow for the natural flow of water and so doesn't send unnecessary warnings.
Clause 10: A unique filter mechanism (called Drift filter) that allows user to define a level of drift that is acceptable and so doesn't send unnecessary warnings.
Clause 11: The combination of technology and software allows for the speed of line movement to be calculated and displayed, preferably as RPM, but can be other units of speed.
Clause 12: A rod detection system that is used as an on/off switch, an auto mute system, a security system and a safety system to warn of possible danger to the rod.
Clause 13: Application software which is available on all platforms and Bluetooth enabled that allows the user to update all programmable parameters, has a log of all events and receives notifications such as warnings, weather and bait timers.

## Claims

1. A bite indicator comprising a housing, a wheel supported by the housing and mounted on an axle for rotation, a surface on the housing for supporting a fishing rod in a position in which a line of the fishing rod makes contact with the wheel to cause the wheel to rotate in response to movement of the line and a sensor for producing an electrical signal with rotation of the wheel, wherein the bite indicator comprises a magnet mounted to rotate with the wheel and the sensor comprises a tunnel magnetoresistance sensor.

2. A bite indicator according to Claim 1 in which the sensor produces an electrical signal which varies throughout 360 degrees of movement of the magnet.

3. A bite indicator according to Claim 1 or Claim 2 in which the magnet is concentrically mounted relative to the wheel.

4. A bite indicator according to any preceding claim in which the magnet is mounted on an end of the axle and wherein the axle comprises a shaft and the magnet is secured to a first longitudinal end of the shaft and the wheel is located along the shaft between the first longitudinal end and a second longitudinal end of the shaft.

5. A bite indicator according to any preceding claim in which the magnet comprises a diametrically magnetised magnet and has a north pole and a south pole on opposite curved sides.

6. A bite indicator according to Claim 5 in which the magnet comprises a disc magnet.

7. A bite indicator according to any preceding claim in which the bite indicator comprising a signal processor to monitor the output from the tunnel magnetoresistance sensor, the signal processor is arranged to periodically measure the output from the tunnel magnetoresistance sensor and the period between measurements can be changed and wherein the signal processor comprises a first period and a second period between measurements depending upon a detected state of the bite indicator.

8. A bite indicator according to Claim 7 in which the period is changed from the first period to the second period by a change of state from a stable state to an alarm state and, in which, the change of state is caused by the bite indicator sensing a change of a monitored signal relative to a threshold.

9. A bite indicator according to Claim 7 or Claim 8 in which the bite indicator comprises a monitoring system to switch the state from a stable state to an alarm state and, in which, the monitoring system monitors the line between the periodic monitoring of the tunnel magnetoresistance signal and wherein the monitoring system can switch the status from a stable state to an alarm state within the set period of measurement of the tunnel magnetoresistance signal in the stable state.

10. A bite indicator according to any preceding claim in which the bite indicator comprises filtering means to filter potential false alarms and, in which, the filter means allows for a change in a movement parameter of the fishing line within a pre-set range without triggering an alarm signal and the filtering means allows for a forward movement up to a forward threshold and allows for a backward movement up to a backward threshold for the movement parameter of the fishing line.

11. A bite indicator according to any preceding claim in which the bite indicator comprises conversion means to convert angular movement detected by the tunnel magnetoresistance sensor to a linear movement of the line.

12. A bite indicator according to any preceding claim in which the bite indicator comprises a screen provided on a front surface of the housing of the bite indicator and, in which, the screen displays movement parameters of the line.

13. A bite indicator according to any preceding claim in which the bite indicator comprises an activation device to change the bite indicator from a non-operational state to an operational state and wherein the activation device comprises a rod sensing device which senses the position of a rod in an operational position relative to the bite indicator, the activation device comprising a rod proximity sensor which detects the proximity of a rod in a retained position on the bite indicator.

14. An angling assembly comprising a rod, a reel, a fishing line and a bite indicator, the bite indicator comprising a housing, a wheel supported by the housing and mounted on an axle for rotation, a surface on the housing for supporting the fishing rod in a position in which the line of the fishing rod makes contact with the wheel to cause the wheel to rotate in response to movement of the line and a sensor for producing an electrical signal with rotation of the wheel, wherein the bite indicator comprises a magnet mounted to rotate with the wheel and the sensor comprises a tunnel magnetoresistance sensor.

15. A method of indicating a fishing bite, the method comprising:
providing a bite indicator comprising a housing, a wheel supported by the housing and mounted on an axle for rotation, the bite indicator further comprising a sensor for producing an electrical signal with rotation of the wheel, wherein the bite indicator comprises a magnet mounted to rotate with the wheel and the sensor comprises a tunnel magnetoresistance sensor; and
supporting a fishing rod on a surface of the housing in a position in which a line of the fishing rod makes contact with the wheel to cause the wheel to rotate in response to movement of the line.
